# FASCICULE DE BREVET EUROPEEN

(11) **EP 0 955 549 B1**
(45) Date de publication et mention de la délivrance du brevet: **27.07.2005**
(21) Numéro de dépôt: 99410065.9
(22) Date de dépôt: 05.05.1999
(51) Int. Cl.: G01R 29/08, G01R 29/10, H01Q 1/24, H04B 17/00

(54) **Système comprenant un dispositif de mesure radiofréquence pour un banc de test industriel**
System mit Vorrichtung zur Radiofrequenzmessungen auf einem industriellen Prüfstand
System comprising an apparatus for radiofrequency measurements on an industrial test bench

(30) Priorité: 05.05.1998 FR 9805905
(43) Date de publication de la demande: 10.11.1999
(73) Titulaire: ARF TEST, 38190 Crolles (FR)
(72) Inventeur: Champaney, Pascal, 38660 Le Touvet (FR)
(74) Mandataire: Dossmann, Gérard

(56) Documents cités:
- US-A- 4 220 955
- US-A- 5 493 702
- US-A- 5 532 703
- US-A- 5 619 213
- PATENT ABSTRACTS OF JAPAN vol. 011, no. 240 (E-529), 6 août 1987 & JP 62 053524 A (SEIKO EPSON CORP), 9 mars 1987
- PATENT ABSTRACTS OF JAPAN vol. 098, no. 005, 30 avril 1998 & JP 10 002920 A (SAITAMA NIPPON DENKI KK), 6 janvier 1998
- PATENT ABSTRACTS OF JAPAN vol. 097, no. 009, 30 septembre 1997 & JP 09 133724 A (MATSUSHITA ELECTRIC IND CO LTD), 20 mai 1997

## Description

### Domaine technique de l'invention

L'invention est relative à un dispositif de mesure pour le test des signaux radioélectriques à haute fréquence émis par un appareil de communication à transmission radio utilisé dans le domaine des télécommunications, de la téléphonie mobile, et de la domotique.

### Etat de la technique

Les applications grand public de ce type de matériels engendrent des grandes séries de fabrication, nécessitant en fin de cycle de production des bancs de test destinés à vérifier le bon fonctionnement des appareils. Les bancs de test font usage d'outillages soumis à un grand nombre de manoeuvres, avec comme conséquence l'usure prématurée des pièces mobiles et des contacts de mesure. Les points de mesure servant à prélever les signaux à radiofréquence sont en effet rapidement affectés d'erreurs de mesure. Les signaux sont d'une manière classique prélevés au moyen de sondes ou pointes de mesure coaxiales.

L'usage de ces contacts mécaniques présentent les inconvénients suivants :
- l'usure prématurée impose un remplacement régulier des pointes et contacts de test en fonction des cadences de fabrication, d'où des frais supplémentaires de maintenance et de contrôle;
- l'agencement coaxial des pointes ne permet pas de garantir la valeur de l'impédance de sortie, laquelle est fondamentale lors de mesures critiques dans les systèmes de modulation de phase;
- le prélèvement des signaux par des contacts mécaniques est impossible sur des appareils ayant une antenne intégrée, où les points de mesure à radiofréquence sont inaccessibles, et ne disposant pas de connecteur externe du côté haute fréquence.

La vérification est alors limitée au test de la carte électronique par un système de mesure conduite, avec comme inconvénient la prévision d'un budget lié au remplacement fréquent des pointes. La répétabilité du test reste cependant fortement altérée par l'usure progressive des contacts de mesure.

Le document JP 09 133 724 décrit un test d'un téléphone portable.

Dans les documents JP 62 053524 et US-A-5619213, des coupleurs d'antennes sont liés à l'exploitation des émetteurs récepteurs radio mobiles. La fonction essentielle de ces dispositifs est la recherche de la plus faible perte d'insertion possible, de manière à conserver les caractéristiques des émetteurs récepteurs. Le domaine d'application du dispositif de la présente demande se limite au seul test des équipements sur un banc de test traitant des forts volumes de production. Il remplace une prise d'information RF conduite par une mesure en rayonné dans un environnement fortement métallique. L'utilisation d'une antenne à la place d'un capteur à champ proche ne permettrait pas d'obtenir la précision souhaitée. En effet, une antenne est considérée comme étant un capteur de champ lointain, qui serait sensible aux champs parasites existant dans un environnement métallique. Les pertes de transmission avec une antenne sont également supérieures, et la bande de fréquence réduite poserait des problèmes de stabilité et d'ajustage.

### Objet de l'invention

L'objet de l'invention consiste à réaliser un système comprenant un dispositif de mesure sans contact pour tester avec précision les signaux radioélectriques émis par un appareil de communication à haute fréquence, indépendamment de l'environnement extérieur.

Le système selon l'invention est caractérisé en ce qu'il comporte :
- un capteur de champ proche monté sur un support à proximité de l'antenne émettrice/réceptrice de l'appareil de communication à transmission radio,
- un circuit de correction d'amplitude du signal détecté par le capteur,
- et un circuit d'adaptation d'impédance à la sortie du dispositif de mesure délivrant le signal de test.

L'utilisation d'un capteur de champ proche, corrigé en amplitude et adapté en impédance à 50 Ohms, permet de travailler dans un environnement fortement métallique, tout en obtenant des mesures très précises. Un tel système de mesure radiofréquence sans contact augmente la fiabilité et la précision du test, l'absence d'usure évitant les opérations de remplacement qui étaient indispensables avec la technique de l'art antérieur. Les mesures radio sur les modulations numériques imposent en effet une parfaite planéité de la réponse en fréquence quitte à avoir des pertes de transmission importantes, lesquelles sont prises en compte lors de la calibration.

Selon une caractéristique de l'invention, le capteur de champ proche est formé par un capteur magnétique, notamment en forme de boucle à induction. Le capteur de champ proche peut également être formé par un capteur électrique, notamment du type capacitif en ligne ou en surface.

Selon une autre caractéristique de l'invention, le circuit de correction d'amplitude est constitué par un réseau passif non résistif comprenant des circuits élémentaires LC agencés entre le capteur et la sortie. Le circuit d'adaptation d'impédance comprend un réseau passif de cellules à composants résistifs ou non résistifs, inséré entre le circuit de correction d'amplitude et la sortie.

Un tel système comprenant un dispositif de mesure sans contact par capteur de champ proche est particulièrement adapté pour équiper un banc de test industriel. Le capteur n'est sensible qu'au champ électrique proche de l'antenne de l'appareil, sans aucune influence de champs parasites en provenance du châssis métallique et du câblage électrique des sondes et des pointes de test à basse fréquence.

D'autres avantages et caractéristiques ressortiront plus clairement de la description qui va suivre d'un mode de réalisation de l'invention, donné à titre d'exemple non limitatif et représenté aux dessins annexés, dans lesquels:
- la figure 1 est une vue synoptique du système comprenant un dispositif de mesure sans contact selon l'invention;
- la figure 2 montre une vue en élévation d'un appareil à tester placé à proximité du système comprenant un dispositif de mesure sans contact;
- la figure 3 représente une vue de profil de la figure 2;
- la figure 4 est une vue schématique en perspective d'un banc de test industriel équipé du système comprenant un dispositif de mesure sans contact selon l'invention.

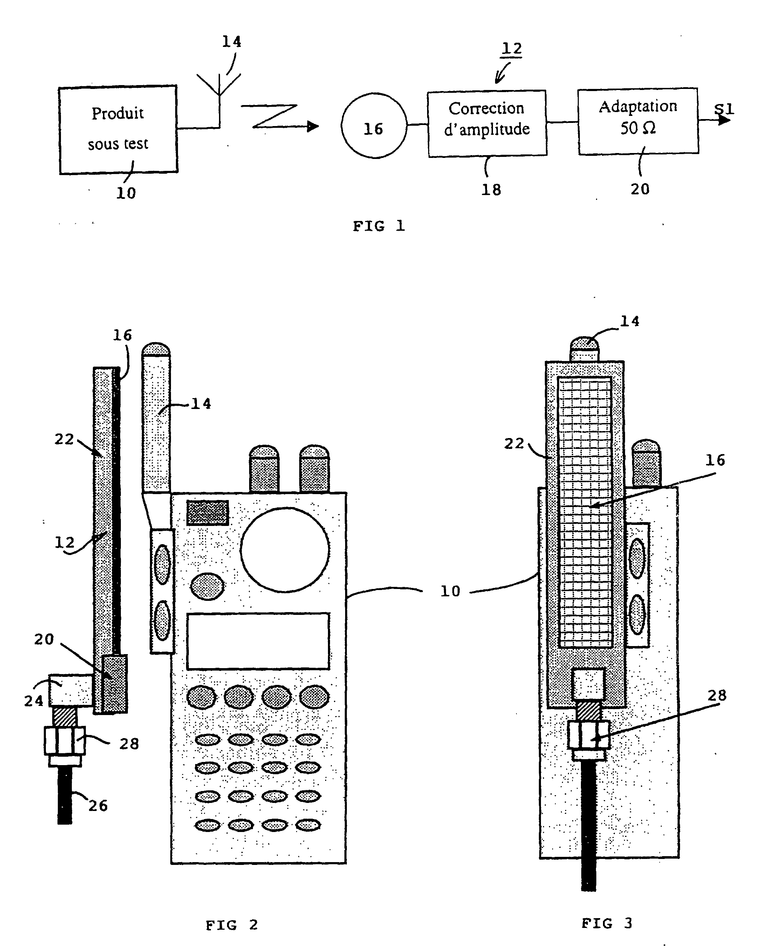

Sur les figures 1 à 3, un appareil de communication 10 à transmission radioélectrique à haute fréquence, utilisé dans le domaine des télécommunications, de la téléphonie mobile, ou de la domotique, est testé au moyen d'un dispositif de mesure radiofréquence 12 sans contact, disposé à proximité de l'antenne 14 rayonnante de l'appareil 10 à tester.

Le dispositif de mesure 12 de l'information à radiofréquence comporte un capteur de champ proche 16 connecté à un circuit de correction d'amplitude 18, et à un circuit d'adaptation d'impédance 20 à 50 Ohms. Le capteur 16 est monté sur un support mécanique 22 s'étendant parallèlement et à faible distance le long de l'antenne 14 émettrice/réceptrice. Le signal de test S1 est prélevé sur une sortie coaxiale 24 du capteur 16 après adaptation de l'impédance, et est transmis vers l'instrumentation grâce à un câble 26 branché à un connecteur 28.

En fonction des fréquences de travail de l'appareil de communication 10, et de la nature de son antenne 14 rayonnante (fouet, boucle,....), le capteur de champ proche 16 peut être soit magnétique en forme de boucle à induction, soit électrique du type capacitif en ligne ou surface. Dans l'exemple des figures 2 et 3, l'antenne 14 de l'appareil 10 est formée par un fouet à quart d'onde, et la prise d'information à radiofréquence est opérée au moyen d'un capteur 16 en ligne destiné à la détection du champ électrique proche engendré par l'antenne 14 lors de l'émission radioélectrique.

L'incidence de la nature de l'antenne 14 sur les caractéristiques du signal de test S1 est nulle suite à l'adaptation d'impédance intégrée. Les pertes de transmission lors de la prise d'information du dispositif de mesure 12 restent inférieures à 15 dB grâce à l'impédance de sortie de 50 Ohms.

Le circuit de correction d'amplitude 18 est formé par un réseau passif non résistif, par exemple à circuits élémentaires LC, destiné à engendrer une réponse inverse du signal en provenance du capteur 16 pour réaliser ladite correction du signal de test S1. Le circuit d'adaptation d'impédance 20 est constitué par un réseau passif de cellules à composants résistifs ou non résistifs.

Le test des caractéristiques d'émission radioélectrique de l'appareil 10 s'effectue de la manière suivante :

Après la mise en service de l'appareil 10 en mode d'émission, le capteur de champ proche 16 est positionné à proximité de l'antenne 14 pour capter les signaux à radiofréquence rayonnés par l'antenne 14. Le capteur 16 n'est sensible qu'au champ proche émis par l'antenne 14, sans être influencé par des champs parasites de l'environnement extérieur. L'absence de contact galvanique avec l'appareil 10 sous test évite tout risque de faux contact. La liaison radioélectrique pour le prélèvement du signal de test S1 évite d'autre part tout contact mécanique avec l'appareil 10, et permet un captage fiable des signaux rayonnés sans usure du capteur 16. L'impédance est adaptée automatiquement à la sortie 24 par le circuit d'adaptation 20, et est figée indépendamment des conditions de mesure.

Une telle mesure radiofréquence sans contact est particulièrement adaptée pour une production en grande série des appareils 10. Le test peut être opéré directement en fin de cycle de fabrication, sans nécessiter d'interruption de la production pour la maintenance de la prise d'information à radiofréquence. L'absence d'usure du capteur 16 permet des mesures très précises du signal de test S1 à ± 1 dB.

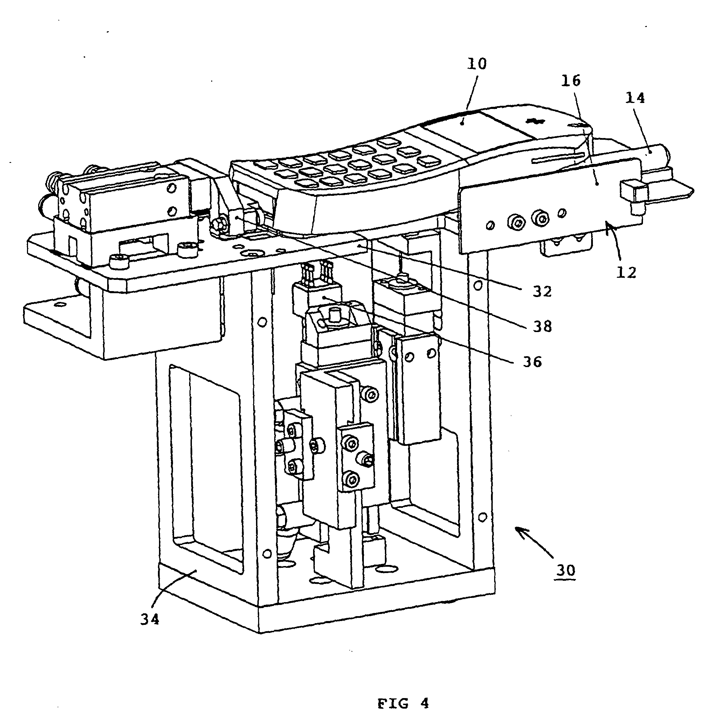

La figure 4 montre un exemple d'application du système comprenant un dispositif de mesure 12 à un banc de test 30 industriel.

L'appareil 10 à tester, par exemple un téléphone mobile, est posé à plat sur une platine 32 métallique du châssis 34, avec son antenne 14 orientée latéralement du côté du capteur de champ proche 16 du dispositif de mesure 12. Le banc de test 30 est équipé d'un premier connecteur 36 à pointes pour l'alimentation de l'appareil 10, et d'un deuxième connecteur 38 de prise d'information à basse fréquence destinés à coopérer avec des bornes correspondantes de l'appareil 10. Le capteur 16 n'est sensible qu'au champ électrique proche de l'antenne 14, sans aucune influence de champs parasites en provenance du châssis 34 métallique et du câblage électrique des sondes et des pointes de test à basse fréquence au niveau des connecteurs 36, 38.

## Revendications

1. Système comprenant un dispositif de mesure (12) pour le test des signaux radioélectriques à haute fréquence émis par un appareil de communication (10) à transmission radio utilisé dans le domaine des télécommunications, de la téléphonie mobile, et de la domotique, le système comprenant un appareil de communication (10) à transmission radio
**caractérisé en ce que** le dispositif de mesure (12) comporte :
- un capteur de champ proche (16) monté sur un support (22) à proximité de l'antenne (14) émettrice/réceptrice de l'appareil de communication (10) à transmission radio,
- un circuit de correction d'amplitude (18) du signal détecté par le capteur (16),
- et un circuit d'adaptation d'impédance (20) à la sortie (24) du dispositif de mesure (12) délivrant le signal de test (S1).

2. Système selon la revendication 1, **caractérisé en ce que** le capteur de champ proche (16) est formé par un capteur magnétique, notamment en forme de boucle à induction.

3. Système selon la revendication 1, **caractérisé en ce que** le capteur de champ proche (16) est formé par un capteur électrique, notamment du type capacitif en ligne ou en surface.

4. Système selon la revendication 1, **caractérisé en ce que** le circuit de correction d'amplitude (18) du signal détecté pour le capteur (16) est constitué par un réseau passif non résistif comprenant des circuits élémentaires LC agencés entre le capteur de champ proche (16), et la sortie (24) du dispositif de mesure (12).

5. Système selon la revendication 1, **caractérisé en ce que** le circuit d'adaptation d'impédance (20) comprend un réseau passif de cellules à composants résistifs ou non résistifs, inséré entre le circuit de correction d'amplitude (18) et la sortie (24) du dispositif de mesure (12).

6. Système selon la revendication 1 ou 5, **caractérisé en ce que** le signal de test (S1) est prélevé à la sortie (24) du dispositif de mesure (12) au moyen d'un connecteur (28) à accès 50 Ohms.

7. Banc de test industriel (30) pour le test d'appareils de communication en fin de cycle de fabrication, **caractérisé en ce qu'**il est équipé d'un système dispositif de mesure (12) selon l'une des revendications 1 à 6.

## Patentansprüche

1. System mit einer Messvorrichtung (12) zum Test von hochfrequenten Funksignalen, die von einem von einem auf dem Gebiet des Fernmeldewesens, der Mobiltelefonie und der Hauselektronik verwendeten Funkübertragungs-Kommunikationsgerät (10) ausgesendet werden, wobei das System ein Funkübertragungs-Kommunikationsgerät (10) aufweist, **dadurch gekennzeichnet, dass** die Messvorrichtung (12) aufweist:
- einen Nahfeldsensor (16), der in der Nähe der Sende-/Empfangsantenne (14) des Funkübertragungs-Kommunikationsgeräts (10) auf einen Träger (22) montiert ist,
- eine Amplitudenkorrekturschaltung (18) für das vom Sensor (16) erfasste Signal,
- und eine Impedanzanpassungsschaltung (20) am Ausgang (24) der Messvorrichtung (12), der das Testsignal (S1) liefert.

2. System nach Anspruch 1, **dadurch gekennzeichnet, dass** der Nahfeldsensor (16) von einem Magnetsensor, insbesondere in Form einer Induktionsschleife, gebildet wird.

3. System nach Anspruch 1, **dadurch gekennzeichnet, dass** der Nahfeldsensor (16) von einem elektrischen Sensor gebildet wird, insbesondere vom kapazitiven Online- oder Flächentyp.

4. System nach Anspruch 1, **dadurch gekennzeichnet, dass** die Amplitudenkorrekturschaltung (18) des für den Sensor (16) erfassten Signals aus einem passiven, nicht resistiven Netz besteht, das LC-Elementarschaltungen aufweist, die zwischen dem Nahfeldsensor (16) und dem Ausgang (24) der Messvorrichtung (12) ausgebildet sind.

5. System nach Anspruch 1, **dadurch gekennzeichnet, dass** die Impedanzanpassungsschaltung (20) ein passives Netz von Zellen mit resistiven oder nicht resistiven Komponenten aufweist, das zwischen die Amplitudenkorrekturschaltung (18) und den Ausgang (24) der Messvorrichtung (12) eingefügt ist.

6. System nach Anspruch 1 oder 5, **dadurch gekennzeichnet, dass** das Testsignal (S1) am Ausgang (24) der Messvorrichtung (12) mittels eines 50-Ohm-Steckverbinders (28) abgegriffen wird.

7. Industrieller Prüfstand (30) für den Test von Kommunikationsgeräten am Ende des Herstellungszyklus, **dadurch gekennzeichnet, dass** er mit einem eine Messvorrichtung (12) aufweisenden System nach einem der Ansprüche 1 bis 6 ausgestattet ist.

## Claims

1. System comprising a measuring device (12) for testing the radiofrequency signals emitted by a radio transmission communication device (10) used in the field of telecommunications, mobile telephony and home automation, the system comprising a radio transmission communication device .(10) **characterized in that** the measuring device (12) includes:
- a near field sensor (16) mounted on a support (22) close to the transmit/receive antenna (14) of the radio transmission communication device (10),
- a circuit (18) for correcting the amplitude of the signal detected by the sensor (16),
- and an impedance matching circuit (20) at the output (24) of the measuring device (12) delivering the test signal (S1).

2. System according to Claim 1, **characterized in that** the near field sensor (16) is formed by a magnetic sensor, in particular in induction loop form.

3. System according to Claim 1, **characterized in that** the near field sensor (16) is formed by an electrical sensor, in particular of the line or surface capacitive type.

4. System according to Claim 1, **characterized in that** the circuit (18) for correcting the amplitude of the signal detected by the sensor (16) is made up of a non-resistive passive network comprising individual LC circuits arranged between the near field sensor (16) and the output (24) of the measuring device (12).

5. System according to Claim 1, **characterized in that** the impedance matching circuit (20) comprises a passive network of cells with resistive or non-resistive components, inserted between the amplitude correction circuit (18) and the output (24) of the measuring device (12).

6. System according to Claim 1 or 5, **characterized in that** the test signal (S1) is sampled at the output (24) of the measuring device (12) using a 50 ohm port connector (28).

7. Industrial test bench (30) for testing communication devices at the end of the production cycle, **characterized in that** it is equipped with a measuring device system (12) according to one of Claims 1 to 6.
